# EUROPEAN PATENT SPECIFICATION

(11) **EP 1 215 301 B1**
(45) Date of publication and mention of the grant of the patent: **17.09.2008**
(21) Application number: 00127256.6
(22) Date of filing: 18.12.2000
(51) Int. Cl.: C23C 8/10, C23C 8/36, C23C 4/18, C23C 14/58

(54) **Method for treating the bond coating of a component**
Verfahren zur Behandlung einer Haftschicht auf einem Bauteil
Procédé de traitement d'une couche de liaison sur un élément

(43) Date of publication of application: 19.06.2002
(73) Proprietor: Alstom Technology Ltd, 5400 Baden (CH)
(72) Inventor: Khan, Abdus S., 5400 Baden (CH); Zagorski, Alexandre, 5408 Ennetbaden (CH); Katsnelson, Savelii S., 630090 Novosibirsk (RU); Pozdniakov, Georgij A., 630055 Novosibirsk (RU)

(56) References cited:
- US-A- 6 042 898
- SCHMITT-THOMAS KH G ET AL: "Diffusion barriers of Al/sub 2/O/sub 3/ to reduce the bondcoat oxidation of MCrAlY alloys" WERKSTOFFE UND KORROSION, OCT. 1992, GERMANY, vol. 43, no. 10, pages 492-495, XP000990103 ISSN: 0043-2822
- MULLER G ET AL: "Oxide scale growth on MCrAlY coatings after pulsed electron beam treatment" 25TH INTERNATIONAL CONFERENCE ON METALLURGICAL COATINGS AND THIN FILMS, SAN DIEGO, CA, USA, 27 APRIL-1 MAY 1998, vol. 108-109, no. 1-3, pages 43-47, XP001004819 Surface and Coatings Technology, 10 Oct. 1998, Elsevier, Switzerland ISSN: 0257-8972
- PATENT ABSTRACTS OF JAPAN vol. 016, no. 054 (C-0909), 12 February 1992 (1992-02-12) & JP 03 257002 A (MATSUSHITA ELECTRIC IND CO LTD), 15 November 1991 (1991-11-15)
- PATENT ABSTRACTS OF JAPAN vol. 010, no. 144 (C-349), 27 May 1986 (1986-05-27) & JP 61 004525 A (HITACHI SEISAKUSHO KK), 10 January 1986 (1986-01-10)

## Description

### FIELD OF INVENTION

The invention relates to a method for treating the bond coating of a component, the bond coating containing aluminum, before applying a ceramic coating on top of the bond coating.

### BACKGROUND OF THS INVENTION

Components designed for the use in the area of high temperature, e.g. blades or vanes of a gas turbine, are usually coated with environmental resistant coatings. The coating protects the base material against corrosion and oxidation due to the thermal effect of the hot environment and consists of an alloy mostly using the elements Al and Cr, e.g. MCrAIY. The MCrAIY class of coatings is the state of the art overlay coatings where M is nickel or cobalt or iron individually or a combination thereof. The MCrAIY is also used as a bond coat for thermal barrier coatings (TBC). The field of MCrAIY class overlay coatings has been an active area of research and a series of patents has been issued in the last twenty years.

For example, NiCrAIY coatings were described in US 3,754,903 and CoCrAlY coatings in US 3,676,085. US 4,346,137 describes improved high temperature fatigue resistant NiCoCrAlY coatings. US 4,419,416, US 4,585,481 and US 4,743,514 describe MCrAIY coatings containing silicon and hafnium. US-4,313,760 describes superalloy coating composition with good oxidation, corrosion and fatigue resistance. A careful assessment clearly demonstrates that the goals of the above mentioned inventions were coatings/bond coats that form a continuous alumina scale and such as US 4,346,137 compositions tailored for fatigue improvement. It is known that fatigue improvement of gamma/beta coatings could not be made without significant loss of alumina forming capability of the MCrAIY coatings by reduction of aluminum within the MCrAIY-coating.

The gamma/gamma prime-(γ/γ')-coatings have an aluminum content typically less than 8 weight percent. For example US 4,973,445 describes coatings which had aluminum in the range of 4 to 7 weight percent and chromium in the range of 25 to 27 weight percent. The alloy has a very good ductility and a thermal expansion coefficient almost identical to those of superalloys. They have a lower expansion mismatch with the substrate and the TBC. A combination of expansion mismatch, physical and mechanical properties of gamma/gamma prime coatings make this class of alloys attractive as coatings and bond coats in thermal barrier coatings (TBC). They form continuous alumina scale at elevated temperatures but tend to form mixed and often discontinuous scale at low temperatures. Therefore, US-5,972,424 discloses a method of forming a aluminum oxide layer on top of a metallic bond coating before application of a ceramic protective layer.

There is a demand for increased efficiency in aircraft and industrial gas turbine engines which is accomplished by increasing the turbine temperatures and optimization of cooling flow. The coatings are therefore used for protection of turbine blades and vanes. The use of TBC in industrial gas turbine engine is becoming increasingly important due to increasing inlet temperatures. The thermal barrier coatings (TBC) applied by electron beam process (EB) fail either at TGO (Thermally Grown Oxide) interface whereas the APS (air plasma sprayed) TBC fails in areas in the vicinity of TGO but within the TBC deposited by APS. In both EB and APS TBC the TGO must be dense and adherent and growth rate should be slow for durable TBC.

For durable thermal barrier coatings the bond coat used must be able to form a continuous and preferably alumina scale under engine operating conditions i.e. at temperatures in the range of 850 to 1000°C. Due to high aluminum content the gamma/beta MCrAIY bond coats generally form a continuous alumina scale at temperatures at or below 1000°C. In contrast, due to low aluminum content the gamma/gamma prime based bond coats are unable to form a dense and continuous scale at temperatures of interest below 1000°C the engine operating conditions.

### SUMMARY OF THE INVENTION

It is the aim of the present invention to overcome the presented disadvantages. It is object of the invention to life improvement of thermal barrier coatings by pre-forming a dense and continuous oxides on bond coats at 1000°C or below and more suitable for gamma/gamma prime based bond coats. The goal is to form continuous and dense oxides on bond coats preferably containing alumina is known to provide durable thermal barrier coatings.

With the invention a method was found for preparing a component designed for high temperature services, e.g. a Ni based superalloy, after coating with a bond coating, the bond coating containing aluminum, before applying a ceramic coating on top of the bond coating, wherein prior to the depositing of the ceramic coating an aluminum oxide film is provided on top of the bond coating and the component is treated by plasma pulses.

The said oxide scale is continuous and may contain pure alumina and or mixed oxides with alumina as inner scale. According to this invention the said scale on top of the bond coat can be formed by pulse plasma exposure in an atmosphere of air or in an atmosphere of air with an elevated partial pressure of oxygen. The method is particularly useful as a pre-treatment for gamma/gamma prime coatings that cannot form continuous and dense film at low temperatures.

The pre-oxidation can be conducted at elevated temperatures for time interval sufficient to form a continuous layer.

A possible content of the three different gamma prime type coatings is written in the table below.

**Coating contents (wt.-%)**

| Coating | Cr | Co | Al | Ta | Y | Si | Fe | Ni |
|---|---|---|---|---|---|---|---|---|
| 1 | 24 | -- | 5 | 1 | 0.5 | 1.2 | -- | Bal. |
| 2 | 12 | 30 | 12 | 0.5 | 0.5 | 1.2 | -- | Bal. |
| 3 | 12 | 30 | 12 | 0.5 | 0.5 | 1.2 | 3 | Bal. |

In one example the component can be a blade or vane of a gas turbine, consisting of a nickel-base-superalloy, which is coated with MCrAIY as a bond coating. The MCrAIY is deposited by any conventional method such as air plasma, LPPS, VPS, HVOF and any other process suitable for deposition of bond or overlay coatings. The ceramic coating is TBC which is deposited by an air plasma or an electro-beam process. In general, for the scope of the invention the bond coating MCrAlY could be of γ/γ'-type or of a γ/β-type.

### DETAILED DESCRIPTION OF THE INVENTION

The invention refers to a method for treating the bond coating of a component, the bond coating containing aluminium, before applying a ceramic coating on top of the bond coating. Prior to the depositing of the ceramic coating an oxide film is provided on top of the bond coating and the component is treated by plasma pulses.

Such components are used for example as blade or vane in gas turbines. Normally they consist of a base material with a bond coating and an addition ceramic over coating. For example as base material is often used a Ni based superalloy, a thermal barrier coating MCrAIY may be used. MCrAIY protective overlay and bond coatings are widely known in the prior art. They are a family of high temperature coatings, wherein M is selected from one or a combination of iron, nickel and cobalt. As an example US-A-3,528,861 or US-A-4,585,481 are disclosing such types of oxidation resistant coatings.US-A-4,152,223 as well discloses such a method of coating and the coating itself. Possible ways of deposition are known in the state of the art as chemical or physical vapour deposition (CVD, PVD), atmospheric plasma spray (APS), low pressure plasma spray (LPPS), vacuum plasma spray (VPS), high velocity oxidant fuel (HVOF), Cold Spray or any other process suitable for deposition. After the coating with MCrAIY a diffusion heat-treatment takes place known in the prior art. A preferred material for ceramic coatings is an yttria-stabilized zirconia which is know as Thermal Barrier Coating (TBC).

The said oxide scale is continuous and may contain pure alumina and or mixed oxides with alumina as inner scale. The method is particularly useful as a pre-treatment for γ/γ'-coatings that can not form continuous and dense film at low temperatures during service.

According to this invention the said scale on top of the bond coat can be formed simultaneously by pulse plasma exposure in an atmosphere of air or in an atmosphere of reduced partial pressure of oxygen.

One possibility is to form the oxidation process in a first step and, subsequently, treat the aluminum oxide scale with said plasma pulses. This leads to more dense layer of existing aluminum oxide scale. The aluminum oxide layer may formed by oxidation or deposited by chemical vapor deposition or any other suitable deposition method known in the art. In any case, the oxidation process and the plasma plus treatment can be repeated in order to create a layer of sufficient density and thickness.

The method producing the plasma pulses can be realized by means of
- Electro-magnetic or electro-thermal pulse plasma gun, which creates a high-speed, high-enthalpy plasma flow. This flow impacts the coating/substrate surface and creates high-pressure and large heat fluxes, which result in a densification of the oxidation layer.
- Other methods, which create high-speed high-enthalpy gas/plasma flows (Detonation-guns, plasma torches etc.)

The pre-oxidation can be conducted at elevated temperatures for a time interval sufficient to form a continuous layer. In an other embodiment after the step of oxidation and before the step of a plasma pulse treatment the surface is cleaned by means of grit blasting, chemical treatment or degreasing. The first formed oxide is discontinuous, irregular and not continuous and it flake off during cooling. Therefore, it is advantageous to remove the first formed by cleaning. Subsequently, the oxides formed are continuous and mostly alumina.

A possible content of the gamma/gamma prime type is written in table 1.

**Tab. 1**

| Coating contents (wt.-%) | | | | | | | | |
|---|---|---|---|---|---|---|---|---|
| Coating | Cr | Co | Al | Ta | Y | Si | Fe | Ni |
| 1 | 24 | -- | 5 | 1 | 0.5 | 1.2 | -- | Bal. |
| 2 | 12 | 30 | 12 | 0.5 | 0.5 | 1.2 | -- | Bal. |
| 3 | 12 | 30 | 12 | 0.5 | 0.5 | 1.2 | 3 | Bal. |

The coating no. 1 could contain Y and Hf as minor reactive elements. Any gamma/beta type of a MCrAIY bond coating could be used within the scope of the invention as well.

## Claims

1. A method for treating a bond coating of a component, the bond coating containing aluminum, before applying a ceramic coating on top of the bond coating, wherein prior to the depositing of the ceramic coating an aluminum oxide film is provided on top of the bond coating and the component is treated by plasma pulses.

2. The method according to claim 1,
wherein the plasma pulse treatment is performed in an atmosphere of air or in an atmosphere under a reduced partial pressure of oxygen.

3. The method according to claim 1 or 2,
wherein the oxidation process and the plasma pulse treatment are performed simultaneously.

4. The method according to claim 1 or 2,
wherein the step of oxidation and the step of a plasma pulse treatment are performed one after the other.

5. The method according to claim 4,
wherein the step of oxidation and the step of a plasma pulse treatment, which are performed one after the other, are repeated.

6. The method according to claim 4 or 5,
wherein the oxidation treatment is performed at an elevated temperature.

7. The method according to claim 4,
wherein after the step of oxidation and before the step of a plasma pulse treatment the surface is cleaned by means of grit blasting, chemical treatment or degreasing.

8. The method according to any of the claims 1 to 7,
wherein plasma pulses are created by an electro-magnetic or an electro-thermal pulse plasma gun or any other devices suitable for producing high-speed, high enthalpy pulses.

9. The method according to anyone of the claims 1 to 7,
wherein the bond coating consists of (wt.-%) 24% Cr, 5% Al, 1% Ta, 0.5% Y, 1.2% Si, balance Ni and unavoidable impurities.

10. The method according to claim 9,
wherein the bond coating contains in addition Hf.

11. The method according to anyone of the claims 1 to 7,
wherein the bond coating consists of (wt.-%) 12% Cr, 30% Co, 12% Al, 0.5% Ta, 0.5% Y, 1.2% Si, balance Ni and unavoidable impurities.

12. The method according to anyone of the claims 1 to 7,
wherein the bond coating consists of (wt.-%) 12% Cr, 30% Co, 12% Al, 0.5% Ta, 0.5% Y, 1.2% Si, 3% Fe, balance Ni and unavoidable impurities.

13. The method according to anyone of the claims 1 to 12,
wherein the component is a blade or vane of a gas turbine, consisting of a nickel base superalloy, the bond coating, which is MCrAlY, is deposited by any method and the ceramic coating is TBC which is deposited by an air plasma or an electro-beam process.

14. The method according to claim 13,
wherein the bond coating MCrAlY having a γ/γ'-structure.

15. The method according to claim 13,
wherein the bond coating MCrAlY having a γ/β-structure.

## Patentansprüche

1. Verfahren zum Behandeln einer Haftschicht eines Bauteils, wobei die Haftschicht Aluminium enthält, vor dem Aufbringen einer Keramikschicht auf der Haftschicht, wobei vor dem Abscheiden der Keramikschicht ein Aluminiumoxidfilm auf der Haftschicht bereitgestellt wird und das Bauteil dann durch Plasmaimpulse behandelt wird.

2. Verfahren nach Anspruch 1,
wobei die Plasmaimpulsbehandlung in einer Atmosphäre aus Luft oder in einer Atmosphäre unter einem reduzierten Sauerstoffpartialdruck durchgeführt wird.

3. Verfahren nach Anspruch 1 oder 2,
wobei der Oxidationsprozeß und die Plasmaimpulsbehandlung simultan durchgeführt werden.

4. Verfahren nach Anspruch 1 oder 2,
wobei der Schritt der Oxidation und der Schritt einer Plasmaimpulsbehandlung nacheinander durchgeführt werden.

5. Verfahren nach Anspruch 4,
wobei der Schritt der Oxidation und der Schritt einer Plasmaimpulsbehandlung, die nacheinander durchgeführt werden, wiederholt werden.

6. Verfahren nach Anspruch 4 oder 5,
wobei die Oxidationsbehandlung bei einer erhöhten Temperatur durchgeführt wird.

7. Verfahren nach Anspruch 4,
wobei nach dem Schritt der Oxidation und vor dem Schritt einer Plasmaimpulsbehandlung die Oberfläche mit Hilfe von Sandstrahlen, chemischer Behandlung oder Entfettung gereinigt wird.

8. Verfahren nach einem der Ansprüche 1 bis 7,
wobei Plasmaimpulse durch eine elektromagnetische oder eine elektrothermische Impulsplasmakanone oder beliebige andere Einrichtungen erzeugt werden, die sich für das Produzieren von Impulsen mit hoher Geschwindigkeit und hoher Enthalpie eignen.

9. Verfahren nach einem der Ansprüche 1 bis 7,
wobei die Haftschicht aus (Gew.-%) 24% Cr, 5% Al, 1% Ta, 0,5% Y, 1,2% Si, Rest Ni und unvermeidbaren Verunreinigungen besteht.

10. Verfahren nach Anspruch 9,
wobei die Haftschicht zusätzlich Hf enthält.

11. Verfahren nach einem der Ansprüche 1 bis 7,
wobei die Haftschicht aus (Gew.-%) 12% Cr, 30% Co, 12% Al, 0,5% Ta, 0,5% Y, 1,2% Si, Rest Ni und unvermeidbaren Verunreinigungen besteht.

12. Verfahren nach einem der Ansprüche 1 bis 7,
wobei die Haftschicht aus (Gew.-%) 12% Cr, 30% Co, 12% Al, 0,5% Ta, 0,5% Y, 1,2% Si, 3% Fe, Rest Ni und unvermeidbaren Verunreinigungen besteht.

13. Verfahren nach einem der Ansprüche 1 bis 12,
wobei das Bauteil eine Laufschaufel oder eine Leitschaufel einer Gasturbine ist, die aus einer Superlegierung auf Nickelbasis besteht, wobei die Haftschicht, die MCrAlY ist, durch ein beliebiges Verfahren abgeschieden wird und die Keramikschicht TBC ist, die durch eine Luftplasma- oder einen Elektrostrahlprozeß abgeschieden wird.

14. Verfahren nach Anspruch 13,
wobei die Haftschicht MCrAlY mit einer γ/γ'-Struktur ist.

15. Verfahren nach Anspruch 13,
wobei die Haftschicht MCrAlY mit einer γ/β-Struktur ist.

## Revendications

1. Procédé de traitement d'une couche de liaison sur un élément, la couche de liaison contenant de l'aluminium, avant l'application d'un revêtement céramique par-dessus la couche de liaison, un film d'oxyde d'aluminium étant mis en place par-dessus la couche de liaison avant le dépôt du revêtement céramique et l'élément étant traité par impulsions de plasma.

2. Procédé selon la revendication 1,
le traitement par impulsions de plasma étant effectué dans une atmosphère d'air ou dans une atmosphère sous pression partielle d'oxygène réduite.

3. Procédé selon la revendication 1 ou 2,
le processus d'oxydation et le traitement par impulsions de plasma étant effectués simultanément.

4. Procédé selon la revendication 1 ou 2,
L'étape d'oxydation et l'étape de traitement par impulsions de plasma étant effectuées l'une après l'autre.

5. Procédé selon la revendication 4,
l'étape d'oxydation et l'étape de traitement par impulsions de plasma, effectuées l'une après l'autre, étant répétées.

6. Procédé selon la revendication 4 ou 5,
le traitement d'oxydation étant effectué à haute température.

7. Procédé selon la revendication 4,
la surface étant nettoyée, après l'étape d'oxydation et avant l'étape de traitement par impulsions de plasma, au moyen d'un grenaillage, d'un traitement chimique ou d'un dégraissage.

8. Procédé selon l'une quelconque des revendications 1 à 7,
des impulsions de plasma étant créées par un canon électromagnétique ou électrothermique à plasma pulsé ou par tout autre dispositif convenant pour produire des impulsions à grande vitesse et à enthalpie élevée.

9. Procédé selon l'une quelconque des revendications 1 à 7,
la couche de liaison étant constituée (% en masse) de 24 % de Cr, 5 % d'Al, 1 % de Ta, 0,5 % de Y, 1,2 % de Si, le reste étant composé de Ni et d'impuretés inévitables.

10. Procédé selon la revendication 9,
la couche de liaison contenant en plus du Hf.

11. Procédé selon l'une quelconque des revendications 1 à 7,
la couche de liaison étant constituée (% en masse) de 12 % de Cr, 30 % de Co, 12 % d'Al, 0,5 % de Ta, 0,5 % de Y, 1,2 % de Si, le reste étant composé de Ni et d'impuretés inévitables.

12. Procédé selon l'une quelconque des revendications 1 à 7, la couche de liaison étant constituée (% en masse) de 12 % de Cr, 30 % de Co, 12 % d'Al, 0,5 % de Ta, 0,5 % de Y, 1,2 % de Si, 3 % de Fe, le reste étant composé de Ni et d'impuretés inévitables.

13. Procédé selon l'une quelconque des revendications 1 à 12, l'élément étant une aube ou une ailette de turbine à gaz, constituée de superalliage à base de nickel, la couche de liaison en MCrAlY étant déposée par un procédé quelconque et le revêtement céramique étant un revêtement de barrière thermique déposé par un processus plasma sous air ou à faisceau électronique.

14. Procédé selon la revendication 13,
le MCrAlY de la couche de liaison présentant une structure γ/γ'.

15. Procédé selon la revendication 13,
le MCrAlY de la couche de liaison présentant une structure γ/β.
